# EUROPÄISCHE PATENTSCHRIFT

(11) **EP 1 703 640 B1**
(45) Veröffentlichungstag und Bekanntmachung des Hinweises auf die Patenterteilung: **17.02.2010**
(21) Anmeldenummer: 06005134.9
(22) Anmeldetag: 14.03.2006
(51) Int. Cl.: H03K 17/95, G08C 21/00

(54) **Berührungslos wirkender Schalter**
Contactless switch
Interrupteur agissant sans contact

(30) Priorität: 18.03.2005 DE 102005013102
(43) Veröffentlichungstag der Anmeldung: 20.09.2006
(73) Patentinhaber: K.A. Schmersal Holding KG, 42279 Wuppertal (DE)
(72) Erfinder: Stratmann, Christoph, 45277 Essen (DE)
(74) Vertreter: Henseler, Daniela

(56) Entgegenhaltungen:
- DE-A1- 10 337 660
- DE-C1- 10 043 237

## Beschreibung

Die Erfindung betrifft einen berührungslos wirkenden Schalter nach dem Oberbegriff des Anspruchs 1.

Aus der DE 103 37 660 A1 ist ein berührungslos wirkender Schalter für eine Rolltorsteuerung bekannt, der Schaltsignale entsprechend der Stellung eines verfahrbaren Rolltors an eine Steuerung zum Anpassen der Verfahrgeschwindigkeit des Rolltors abhängig von der jeweiligen Stellung liefert, damit das Rolltor optimal beschleunigt, schnell verfahren und langsam in die jeweilige Endstellung heineinbewegt wird. Hierzu sind entlang des Seitenrandes des Rolltors passive RFID-Transponder angeordnet, die als Betätiger für einen ortsfest an einem Rolltorrahmen befestigten Sensor des Schalters wirken. Der Sensor sendet dabei über eine Spule eines stromversorgten Sendeempfängers ein Abfragesignal aus und erkennt eine Stellung des Rolltors, sobald ein RFID-Transponder infolge ausreichender Nähe zur Spule ein Antwortsignal zurücksendet. Die mit dem bekannten Schalter erzielbare Genauigkeit der Bestimmung der Stellung ist somit von der Form der Strahlungskeule des vom Sendeempfänger ausgestrahlten elektromagnetischen Felds abhängig und damit in der Praxis gering. Der bekannte Schalter eignet sich daher nicht für eine genaue Bestimmung der Stellung des beweglichen Teils, um beispielsweise festzustellen, ob eine Schutztür weit genug geschlossen ist, um von einer berührungslos wirkenden Zuhaltung sicher zugehalten zu werden.

Zur genaueren Überwachung der Stellung eines beweglichen Teils gegenüber einem feststehenden Teil sind induktive Näherungsschalter bekannt, die ein vom Abstand der beiden Teile abhängiges Spannungssignal liefern, vgl. z.B. DE 44 27 283 C1. Diese Vorrichtungen sind jedoch eigenständig und benötigen einen eigenen Sensor sowie eine eigene Auswerteschaltung.

Der Erfindung liegt daher die Aufgabe zugrunde, einen berührungslos wirkenden Schalter nach dem Oberbegriff des Anspruchs 1 zu schaffen, der bei einfachem Aufbau zusätzlich zur eindeutigen Identifikation eines Teils eine genaue Abstandsbestimmung ermöglicht und dabei kostengünstig herstellbar ist.

Diese Aufgabe wird entsprechend den Merkmalen des Anspruchs 1 gelöst.

Hierdurch wird ein berührungslos wirkender Schalter zum Erfassen der Position eines ersten Teils gegenüber einem zweiten Teil geschaffen, mit einem von einer elektrischen Versorgungsquelle stromversorgten Sendeempfänger zur Anbringung an einem der Teile, der eine an eine Sendeempfangsschaltung angeschlossene Spule zum Aussenden eines Abfragesignals und zum Empfangen eines in Reaktion auf das Abfragesignal von einem an dem anderen Teil anbringbaren Transponder aussendbaren Antwortsignals umfaßt, wobei eine Näherungsschaltung eingangsseitig mit einem Anschluß der Spule und ausgangsseitig mit einer Auswerteschaltung für die Amplitude der von der Spule abgegriffenen Spannung zum Bestimmen des Abstands zwischen den Teilen verbunden ist. Dadurch werden eine Identifikation eines Teils mittels eines Transponders sowie eine genaue induktionsbasierte Abstandsbestimmung zwischen den Teilen mit nur einem Sensor und einer gemeinsamen Auswerteschaltung in einem einfach aufgebauten und kostengünstig herstellbaren Schalter ermöglicht. Durch Nutzung zweier unterschiedlicher Effekte wird zudem eine für Sicherheitsanwendungen zweckmäßige Redundanz erzielt.

Die Amplitude ist dabei zweckmäßigerweise die maximale Amplitude des an der Spule abgegriffenen Wechselspannungssignals oder die Amplitude des an der Spule abgegriffenen und gleichgerichteten Wechselspannungssignals. Diese Amplituden sind mit einfachen Bauteilen für eine weitere Verarbeitung erzeug- bzw. in einem Microcontroller od.dgl. aus dem Wechselspannungssignal berechenbar.

Die Auswerteschaltung umfaßt zweckmäßigerweise einen Komparator zum Vergleichen der Amplitude mit einem Schwellenwert. Hierdurch ist es ohne großen Aufwand feststellbar, ob ein Grenzabstand zwischen den Teilen unter- oder überschritten ist.

Zweckmäßigerweise ist ein Freigabesignal bei eindeutiger Identifikation des Transponders nur dann erzeugbar, wenn die Amplitude einen Schwellenwert überschreitet. Hierdurch kann bei der Montage des Schalters durch einfaches Einstellen des Schwellenwerts der Grenzabstand zwischen den Teilen eingestellt werden, bei dessen Überschreitung das Freigabesignal erzeugt wird.

Die Näherungsschaltung umfaßt zweckmäßigerweise einen A/D-Wandler. Hierdurch kann das dem Abstand entsprechende Signal digital beispielsweise in einem Signalprozessor, Microcontroller od.dgl. ausgewertet werden.

Der Transponder ist zweckmäßigerweise ein Stab-Transponder. Hierdurch ergibt sich eine im Vergleich zu Scheiben-Transpondern gerichtetere Empfangscharakteristik und eine erhöhte störungsfreie Packungsdichte.

Die Auswerteschaltung ist zweckmäßigerweise zum Auswerten des Antwortsignals auch an die Sendeempfangsschaltung gekoppelt. Hierdurch können mit nur einer insbesondere microcontrollerbasierten Auswerteschaltung die Transponderinformation und die Näherungsinformation ausgewertet werden.

Die Sendeempfangsschaltung umfaßt zweckmäßigerweise eine durch die Auswerteschaltung schaltbare Anregungsschaltung für die Spule. Hierdurch kann die Anregung der Spule entsprechend den Erfordernissen zeitlich gesteuert und bei Bedarf abgeschaltet werden, beispielsweise um bei einer Verwendung mehrerer Schalter in einer batteriebetriebenen Einrichtung Energie zu sparen.

Das Frequenzfilter und/oder eine Gleichspannungsschaltung können durch eine Programmierung eines Micorcontrollers realisiert sein, der zweckmäßigerweise Teil der Auswerteschaltung ist. Hierdurch können Bauteile entfallen und durch eine signalverarbeitende Komponente, insbesondere ein Programm, im Microcontroller ersetzt werden, wodurch sich der Aufbau des Schalters weiter vereinfacht.

Weitere Ausgestaltungen der Erfindung sind der nachfolgenden Beschreibung und den Unteransprüchen zu entnehmen.

Die Erfindung wird nachstehend anhand von in den beigefügten Abbildungen dargestellten Ausführungsbeispielen näher erläutert.
Fig. 1 zeigt schematisch einen Schalter an einem Teil und einen Transponder an einem anderen Teil einer stellungsüberwachten Vorrichtung.
Fig. 2 illustriert den Betrieb des Schalters an einem Autokran.
Fig. 3 zeigt die Ausgangssignale des Schalters der Fig. 2.

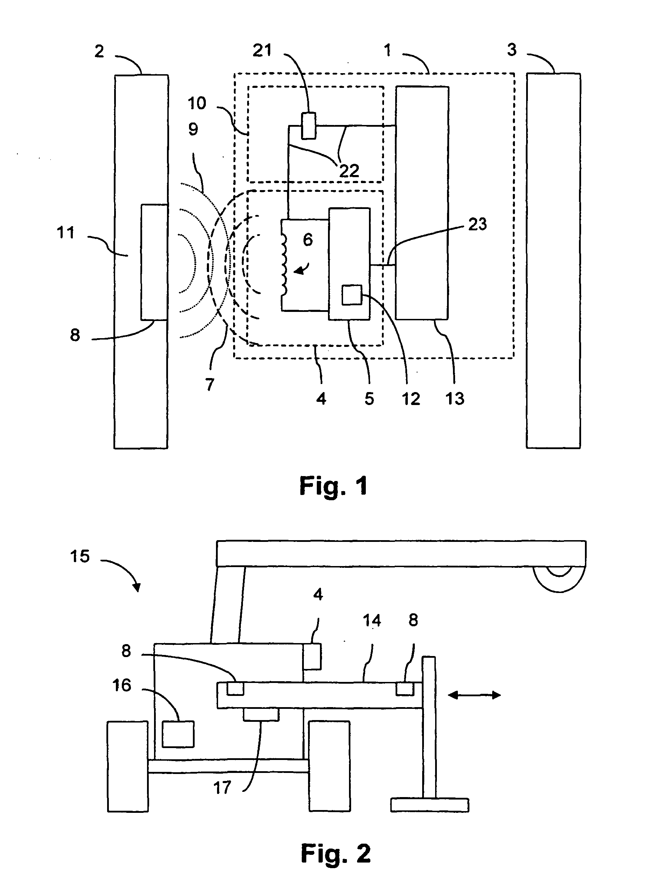

Der in Fig. 1 dargestellte berührungslos wirkende Schalter 1 zum Erfassen der Position eines ersten Teils 2, beispielsweise einer ausfahrbaren Stütze eines Autokrans oder einer Sicherheitstür, gegenüber einem zweiten Teil 3, beispielsweise eines Rahmenteils des Autokrans bzw. eines Türrahmens, umfaßt einen beispielsweise über einen Bus oder eine Batterie stromversorgten Sendeempfänger 4 am Teil 3 mit einer an eine Sendeempfangsschaltung 5 angeschlossenen Spule 6 zum Aussenden eines Abfragesignals 7 in Reaktion auf eine die Spule 6 anregende Wechselspannung und zum Empfangen eines in Reaktion auf das Abfragesignal 7 von einem am Teil 2 angebrachten und zweckmäßigerweise passiven Transponder 8 aussendbaren Antwortsignals 9.

Ferner ist eine Näherungsschaltung 10 auf Induktionsbasis zum Bestimmen des Abstands zwischen den Teilen 2, 3 vorgesehen, die wie folgt arbeitet. Die die Spule 6 anregende Wechselspannung führt zu einer Aussendung elektromagnetischer Wellen von der Spule 6, die das Abfragesignal 7 bilden und nur zu einem Teil vom Transponder 8 absorbiert und zum Erzeugen des Antwortsignals 9 verwendet werden. Der vom Transponder 8 nicht absorbierte Teil des Abfragesignals dringt in das den Transponder 8 umgebende Material 11 des Teils 2 ein und induziert dort Wirbelströme, die wiederum zur Dämpfung des Feldes der Spule 6 führen. Das Ausmaß der Bedämpfung ist abhängig von den Eigenschaften des Materials 11, insbesondere dessen Leitfähigkeit für elektrischen Strom, und eine Funktion des Abstands zwischen der Spule 6 und dem Material 11. Bei geringer Entfernung findet eine starke Bedämpfung statt, während bei großer Entfernung eine geringe Bedämpfung erfolgt.

Zur Bestimmung des Abstands zwischen der Spule 6 und dem Material 11 greift die Näherungsschaltung 10 die an der Spule 6 anliegende Wechselspannung ab und leitet sie hier einem Frequenzfilter 21, beispielsweise einem Bandpaßfilter, zu. Das Frequenzfilter 21 läßt hier lediglich Wechselspannungen mit einer Frequenz in einem Bereich um die die Spule 6 anregende Frequenz herum passieren, also nur die die Anregung der Spule 6 dämpfenden Komponenten. Störsignale und die durch die Modulation des Antwortsignals 9 entstandenen anderen Frequenzkomponenten werden so für die Abstandsbestimmung ausgeblendet. Gegebenenfalls ist dem Frequenzfilter 21 ein Gleichspannungswandler nachgeschaltet oder in diesem integriert. Der Gleichspannungswandler stellt an seinem Ausgang eine Gleichspannung mit einer Amplitude bereit, die die maximale Amplitude der Wechselspannung, die Amplitude der gleichgerichteten Wechselspannung oder eine Amplitude, die die maximale Amplitude der Wechselspannung auf andere Weise repräsentiert, bereit. Die Amplitude, die ein Maß für den Abstand zwischen den Teilen 2, 3 ist, wird zweckmäßigerweise unter Zwischenschaltung eines Analog/Digital-Wandlers einer insbesondere digitalen Auswerteschaltung 13 in Form eines Microcontrollers od.dgl. zugeführt, die hier zur gemeinsamen Auswertung des Antwortsignals 9 auch an die Sendeempfangsschaltung 5 gekoppelt ist und gegebenenfalls eine darin enthaltene Anregungsschaltung 12 zum Anregen der Spule 6 schalten kann. Die digitale Auswerteschaltung 13 kann signalverarbeitenden Programmcode umfassen, der die Funktion des Frequenzfilters 21 und gegebenenfalls des Gleichspannungswandlers übernimmt.

Der Schalter 1 weist für die Auswertung des Abstands zwischen der Spule 6 und dem Material 11 des Teils 2 einen Pfad 22 auf. Teil des Pfades 22 ist die Näherungsschaltung 10. Über den Pfad 22 ist die Spule 6 mit der Auswerteschaltung 13 verbunden. Es liegt ein zweiter Pfad 23 vor, der von der Sendeempfangsschaltung 5 zur Auswerteschaltung 13 führt. Der zweite Pfad 23 wird zur Auswertung des durch den Transponder 8 ausgesendeten Antwortsignals 9 verwendet. Das Antwortsignal 9 kann die Identität des Transponders 8, d.h. die ID des Transponders 8, beinhalten. Die beiden Pfade 22, 23 arbeiten unabhängig voneinander. Der Abstand zwischen Spule 6 und Material 11 des Teils 2 ist präzise und permanent bestimmbar. Das Abfragesignal 7 ist ein Trägersignal mit konstanter Frequenz, dessen Amplitude durch das angenäherte Material 11 des Teils 2 bzw. des Transponders 8 belastet wird, wodurch die Amplitude des Abfragesignals 7 kleiner wird. Die Veränderung der Amplitude wird in beiden Pfaden 22, 23 verwendet. Die Auswertung des Abstands erfolgt permanent. Die Kommunikation zwischen Sendeempfangsschaltung 5 und dem Transponder 8 findet in einem Wechseldialog statt. Die ID des Transponders 8 kann zeitgleich mit der Auswertung des Abstands erkannt werden. Es ist auch möglich, daß Daten durch Modulation des Abfragesignals 7 in einen Speicher des Transponders 8 geschrieben werden können. Es kann insbesondere vorgesehen sein, Zählerstande in einem Speicher des Transponders 8 zu speichern. Es kann insbesondere ein Zählerstand vorgesehen sein, der angibt, wie oft der Transponder 8 bisher in den Abfragebereich des Schalters 1 kam, d.h. an den Schalter 1 angenähert wurde. Ein Zählerstand kann durch die Auswerteschaltung 13 und die Sendeempfangsschaltung 5 gezielt abgefragt und im Speicher des Transponders 8 bei Bedarf geändert werden.

Die gemessene Entfernung und/oder eine Information betreffend den Transponder 8 können an einem Ausgang oder an getrennten Ausgängen Schalters 1 insbesondere digital bereitgestellt werden. Zusätzlich oder statt dessen kann ein Schaltsignal an einem Ausgang des Schalters 1 bereitgestellt werden, wenn ein bestimmter Transponder 8 vom Schalter 1 erkannt wird und die Entfernung bestimmten Vorgaben entspricht. Hierzu können im Schalter 1 Informationen betreffend einen oder mehrere zugeordnete Transponder 8 und eine Entfernung oder einen Entfernungsbereich oder eine Grenzentfernung, die unter- oder überschritten werden muß, oder andere Bedingungen betreffend einen oder mehrere Transponder und die Entfernung enthalten sein.

Der Schalter 1 ist beispielsweise zur Bestimmung der Position einer ausfahrbaren Stütze 14 eines Autokrans 15 verwendbar, vgl. Fig. 2.

Eine Kransteuerung 16 veranlaßt dabei das Ausfahren der Stütze 14 durch einen Antrieb 17. In der Stütze 14 sind an interessierenden Stellen Transponder 8, hier in Form insbesondere flächenbündig angeordneter RFID-Stabtransponder, vorgesehen, die beim Ausfahren der Stütze 14 nacheinander am ortsfest am Rahmen des Autokrans 15 befestigten Sendeempfänger 4 vorbeigefahren werden.

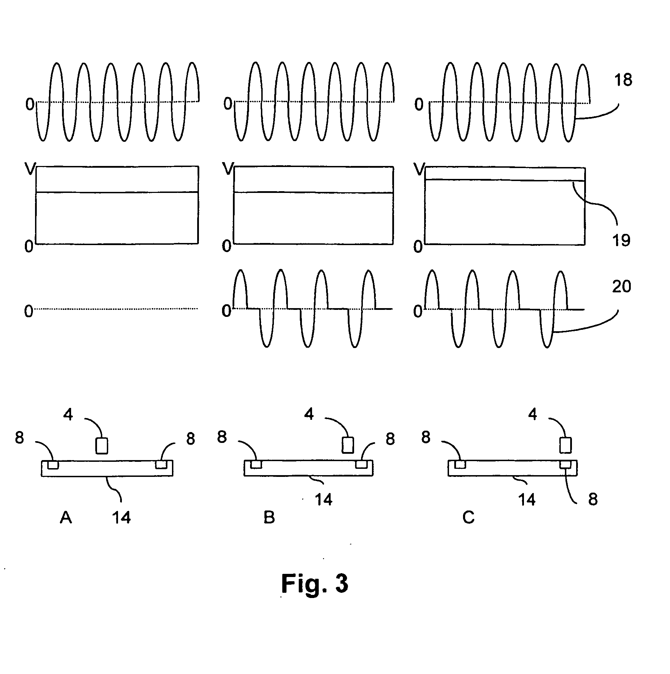

Beim Vorbeifahren ergibt sich der in Fig. 3 in drei Spalten für jeweils eine Stellung A, B, C der Stütze dargestellte Signalverlauf.

Ein Abfragesignal 18 in Form eines elektromagnetisches Wechselfelds mit hier bei beispielsweise 125 kHz konstanter und gegebenenfalls variierender Frequenz, das markiert sein und amptlituden- oder frequenzmoduliert Informationsbits für die Transponder 8 enthalten kann, wird kontinuierlich oder gegebenenfalls periodisch von der Spule 6 des Sendeempfängers 4 in Reaktion auf eine Anregung durch die Sendeempfangsschaltung 5 ausgesendet.

In der Stellung A befindet sich kein Transponder 8 in der Nähe des Sendeempfängers 4. Das Abfragesignal 18 wechselwirkt daher ausschließlich mit dem Material 11 der Stütze 14 und wird durch dieses gedämpft. Die Amplitude der an der Spule 6 anliegenden, gedämpften Wechselspannung ist als Signal 19 in der linken Spalte der Fig. 3 dargestellt.

In der Stellung B liegt ein Transponder 8 im Bereich des durch den Sendeempfänger 4 ausgestrahlten Abfragesignals 18. Ein Teil des Abfragesignals 18 wird von einer Spule im Transponder 8 empfangen. Zweckmäßigerweise liefert die Energie des empfangenen Teils des Abfragesignals 18 die Betriebsenergie für den Transponder 8, der jedoch auch eigenständig beispielsweise über eine Batterie stromversorgt sein kann. Der Transponder 8 sendet in Reaktion auf das Abfragesignal 18 ein Antwortsignal 20 aus. Das Antwortsignal 20 kann im einfachsten Fall eine bestimmte Frequenz aufweisen oder dem Abfragesignal 18 seriell Informationsbits, z.B. eine eindeutige Transponderkennung, aufmodulieren. Das Antwortsignal 20 kann zudem von den empfangenen Informationsbits abhängen, beispielsweise kann im Transponder 8 ein Schlüssel abgelegt sein, mit dem empfangene Informationsbits verschlüsselt und anschließend an den Sendeempfänger 5 zurückgesendet werden. Das vom Transponder 8 in der Stellung B ausgesandte Antwortsignal 20 wird von der Spule 6 empfangen und in der Auswerteschaltung 13 analysiert. Hierzu kann die Frequenz des Antwortsignals 20 oder eine Markierung erkannt und so festgestellt werden, ob ein bestimmter Transponder 8 vorhanden ist. Das Signal 19 bleibt in der Stellung B im wesentlichen unverändert.

In der Stellung C liegt der Transponder 8 wie bereits in der Stellung B im Bereich des durch den Sendeempfänger 4 ausgestrahlten Abfragesignals 18 und kann eindeutig durch Auswerten des Antwortsignals 20 erkannt werden. Zusätzlich befindet sich der Bereich unter dem Transponder 8 in der Stellung C direkt gegenüber dem Sendeempfänger 4. Dieser Bereich ist zur Aufnahme des Transponder 8 ausgespart, so daß das Material 11 weiter von der Spule 6 des Sendeempfängers 4 entfernt ist. Durch den vergrößerten Abstand zwischen dem Material 11 und der Spule 6 ist das Signal 19 stärker.

Die Auswerteschaltung 13 des Schalters 1 ist zweckmäßigerweise so ausgestaltet, daß sie im Fall der ausfahrbaren Stütze 14 ein Freigabesignal zum Betrieb des Autokrans 15 nur dann erzeugt, wenn die Stütze 14 in der Stellung C vollständig ausgefahren ist, d.h. wenn einerseits der der Stellung C zugeordnete Transponder 8 identifiziert ist und andererseits ein Schwellenwert für die Amplitude überschritten ist oder die Amplitude von dem Wert der Stellung B auf den Wert der Stellung C wechselt oder die Amplitude innerhalb eines vorgebbaren Spannungsbereichs liegt.

Die die gemessene Entfernung repräsentierende Information, hier das Signal 19, und die Information betreffend einen Transponder, hier das Antwortsignal 20, können auch auf andere Weise miteinander verknüpft werden, um das Freigabesignal zu erzeugen. Beispielsweise können die Änderungen des Signals 19 gezählt werden, wobei dann zweckmäßigerweise an der der Spule 6 zugewandten Oberfläche des Teils 2 insbesondere regelmäßig beabstandete Einkerbungen vorgesehen sind, oder der Absolutbetrag des Spannungswerts des Signals 19 berücksichtigt werden. Zudem kann der Schalter das Signal 19 und das Antwortsignal 20 repräsentierende Daten über einen Bus an eine Steuerung senden, die die weitere Auswertung übernimmt und abhängig hiervon Steuersignale erzeugt, wobei der Schalter 1 dann ein Schaltsignal nicht bereitstellen muß.

## Patentansprüche

1. Berührungslos wirkender Schalter (1) zum Erfassen der Position eines ersten Teils (2) gegenüber einem zweiten Teil (3), mit einem von einer elektrischen Versorgungsquelle stromversorgten Sendeempfänger (4) zur Anbringung an einem der Teile (3), der eine an eine Sendeempfangsschaltung (5) angeschlossene Spule (6) zum Aussenden eines Abfragesignals (7) und zum Empfangen eines in Reaktion auf das Abfragesignal (7) von einem an dem anderen Teil (2) anbringbaren Transponder (8) aussendbaren Antwortsignals (9) umfaßt, **dadurch gekennzeichnet, daß** neben einem ersten Pfad für die Verarbeitung des Antwortsignals (9) zu einer Auswerteschaltung (13) ein zweiter Pfad mit einer Näherungsschaltung (10) vorgesehen ist, die eingangsseitig mit einem Anschluß der Spule (6) und ausgangsseitig mit der Auswerteschaltung (13) für die Amplitude der von der Spule (6) abgegriffenen Spannung zum Bestimmen des Abstands zwischen den Teilen (2, 3) verbunden ist.

2. Schalter nach Anspruch 1, **dadurch gekennzeichnet, daß** die Näherungsschaltung (10) ein Frequenzfilter (21) umfaßt, dessen Eingang mit dem Anschluß der Spule (6) verbunden ist.

3. Schalter nach Anspruch 1 oder 2, **dadurch gekennzeichnet, daß** die Amplitude die maximale Amplitude des an der Spule (6) abgegriffenen Wechselspannungssignals oder die Amplitude des an der Spule (6) abgegriffenen und gleichgerichteten Wechselspannungssignals ist.

4. Schalter nach einem der Ansprüche 1 bis 3, **dadurch gekennzeichnet, daß** die Auswerteschaltung (13) einen Komparator zum Vergleichen der Amplitude mit einem Schwellenwert umfaßt.

5. Schalter nach einem der Ansprüche 1 bis 4, **dadurch gekennzeichnet, daß** ein Freigabesignal bei eindeutiger Identifikation des Transponders (8) nur dann erzeugbar ist, wenn die Amplitude einen Schwellenwert überschreitet.

6. Schalter nach einem der Ansprüche 1 bis 5, **dadurch gekennzeichnet, daß** die Näherungsschaltung (10) einen A/D-Wandier umfaßt.

7. Schalter nach einem der Ansprüche 1 bis 6, **dadurch gekennzeichnet, daß** der Transponder ein Stab-Transponder ist.

8. Schalter nach einem der Ansprüche 1 bis 7, **dadurch gekennzeichnet, daß** die Auswerteschaltung (13) zum Auswerten auch des Antwortsignals (9) an die Sendeempfangsschaltung (5) gekoppelt ist.

9. Schalter nach Anspruch 8, **dadurch gekennzeichnet, daß** die Sendeempfangsschaltung (5) eine durch die Auswerteschaltung (13) schaltbare Anregungsschaltung (12) für die Spule (6) umfaßt.

10. Schalter nach einem der Ansprüche 1 bis 9, **dadurch gekennzeichnet, daß** die Auswerteschaltung (13) einen Microcontroller umfaßt und ein Frequenzfilter (21) und/oder eine Gleichspannungsschaltung durch eine Programmierung des Microcontrollers realisiert ist.

## Claims

1. Switch (1) acting in contactless fashion for the purpose of detecting the position of a first part (2) with respect to a second part (3), having a transceiver (4) for attachment to one of the parts (3), which transceiver (4) is supplied with power by an electrical supply source and comprises a coil (6), which is connected to a transmission/reception circuit (5), for the purpose of transmitting an interrogation signal (7) and for the purpose of receiving a response signal (9), which can be transmitted in response to the interrogation signal (7) by a transponder (8) which can be arranged on the other part (2), **characterized in that**, in addition to a first path for processing the response signal (9) to an evaluation circuit (13), a second path is provided which has a proximity circuit (10), which is connected on the input side to a connection of the coil (6) and on the output side to the evaluation circuit (13) for the amplitude of the voltage tapped off by the coil (6) for the purpose of determining the distance between the parts (2, 3).

2. Switch according to Claim 1, **characterized in that** the proximity circuit (10) comprises a frequency filter (21), whose input is connected to the connection of the coil (6).

3. Switch according to Claim 1 or 2**, characterized in that** the amplitude is the maximum amplitude of the AC voltage signal tapped off at the coil (6) or the amplitude of the AC voltage signal tapped off at the coil (6) and rectified.

4. Switch according to one of Claims 1 to 3, **characterized in that** the evaluation circuit (13) comprises a comparator for the purpose of comparing the amplitude with a threshold value.

5. Switch according to one of Claims 1 to 4, **characterized in that** an enable signal can only be produced in the case of unique identification of the transponder (8) when the amplitude exceeds a threshold value.

6. Switch according to one of Claims 1 to 5, **characterized in that** the proximity circuit (10) comprises an analogue-to-digital converter.

7. Switch according to one of Claims 1 to 6, **characterized in that** the transponder is a rod transponder.

8. Switch according to one of Claims 1 to 7, **characterized in that** the evaluation circuit (13) is coupled to the transmission/reception circuit (5) for the purpose of also evaluating the response signal (9).

9. Switch according to Claim 8, **characterized in that** the transmission/reception circuit (5) comprises an excitation circuit (12), which can be switched by the evaluation circuit (13), for the coil (6).

10. Switch according to one of Claims 1 to 9, **characterized in that** the evaluation circuit (13) comprises a microcontroller, and a frequency filter (21) and/or a DC voltage circuit is implemented by programming of the microcontroller.

## Revendications

1. Commutateur (1) agissant sans contact pour la saisie de la position d'une première pièce (2) vis-à-vis d'une deuxième pièce (3), avec un récepteur-récepteur (4), alimenté par une source d'énergie électrique, et à apposer à une des pièces (3), qui comprend une bobine (6) connectée à un circuit émetteur-récepteur (5) pour l'émission d'un signal d'interrogation (7) et la réception d'un signal de réponse (9), qui peut être émis en réponse au signal d'interrogation (7) par un transpondeur (8) apposable à l'autre pièce (2), **caractérisé en ce qu'**une deuxième liaison avec un circuit d'approximation (10) est prévu en plus d'une première liaison pour le traitement du signal de réponse (9) vers un circuit d'évaluation (13), qui est relié, à l'entrée, à une connexion avec la bobine (6), et à la sortie au circuit d'évaluation (13) de l'amplitude de la tension mesurée au niveau de la bobine (6), afin de déterminer la distance entre les pièces (2,3).

2. Commutateur selon la revendication 1, **caractérisé en ce que** le circuit d'approximation (10) comprend un filtre de fréquences (21), dont l'entrée est reliée à la connexion de la bobine (6).

3. Commutateur selon la revendication 1 ou 2, **caractérisé en ce que** l'amplitude est l'amplitude maximale du signal de tension alternative mesurée au niveau de la bobine (6), ou l'amplitude du signal de tension alternative, mesurée au niveau de la bobine (6), et redressée.

4. Commutateur selon l'une des revendications 1 à 3, **caractérisé en ce que** le circuit de détection (13) comprend un comparateur pour comparer l'amplitude à une valeur de seuil.

5. Commutateur selon l'une des revendications 1 à 4, **caractérisé en ce qu'u**n signal d'activation, lors d'une identification indubitable du transpondeur (8), ne peut seulement être émis que si l'amplitude dépasse une valeur de seuil.

6. Commutateur selon l'une des revendications 1 à 5, **caractérisé en ce que** le circuit d'approximation (10) comprend un convertisseur analogique-numérique.

7. Commutateur selon l'une des revendications 1 à 6, **caractérisé en ce que** le transpondeur est un transpondeur ayant une forme de tige.

8. Commutateur selon l'une des revendications 1 à 7, **caractérisé en ce que** le circuit d'évaluation (13) est couplé au circuit émetteur-récepteur (5) aussi pour l'évaluation du signal de réponse (9).

9. Commutateur selon la revendication 8, **caractérisé en ce que** le circuit émetteur-récepteur (5) comprend un circuit d'excitation (12) pour la bobine (6), commutable par l'intermédiaire du circuit d'évaluation (13).

10. Commutateur selon l'une des revendications 1 à 9, **caractérisé en ce que** le circuit d'évaluation (13) comprend un microcontrôleur et un filtre de fréquences (21) et/ou circuit en courant continu réalisé par une programmation du microcontrôleur.
